# FASCICULE DE BREVET EUROPEEN

(11) **EP 4 557 932 B1**
(45) Date de publication et mention de la délivrance du brevet: **18.02.2026**
(21) Numéro de dépôt: 24211903.0
(22) Date de dépôt: 08.11.2024
(51) Int. Cl.: H10N 70/20

(54) **CELLULE MÉMOIRE À CHANGEMENT DE PHASE ET PROCÉDÉ DE FABRICATION CORRESPONDANT**
PHASENWECHSELSPEICHERZELLE UND EIN ENTSPRECHENDES HERSTELLUNGSVERFAHREN
PHASE CHANGE MEMORY CELL AND A CORRESPONDING FABRICATION PROCESS

(30) Priorité: 17.11.2023 FR 2312658
(43) Date de publication de la demande: 21.05.2025
(73) Titulaire: Commissariat à l'Energie Atomique et aux Energies Alternatives, 75015 Paris (FR)
(72) Inventeur: NAVARRO, Gabriele, 38054 Grenoble Cedex 09 (FR); DE CAMARET, Clément, 38054 Grenoble Cedex 09 (FR)
(74) Mandataire: Cabinet Beaumont

(56) Documents cités:
- US-A1- 2009 189 139
- US-A1- 2013 075 682
- US-A1- 2016 072 059

## Description

### Domaine technique

La présente description concerne de façon générale les dispositifs électroniques, plus particulièrement les mémoires à changement de phase et les cellules de telles mémoires.

### Technique antérieure

Dans une mémoire à changement de phase, le matériau à changement de phase de chaque cellule est capable d'alterner, sous l'effet d'une élévation de température, entre une phase amorphe, électriquement résistive, et une phase cristalline, électriquement conductrice. Les phases amorphe et cristalline du matériau à changement de phase d'une cellule permettent de définir, pour cette cellule, deux états mémoire correspondant par exemple respectivement aux valeurs logiques 0 et 1.

Des mémoires à changement de phase sont actuellement intégrées dans de nombreux types de dispositifs électroniques, par exemple des microcontrôleurs. Pour certaines applications, les mémoires à changement de phase sont soumises à de fortes températures susceptibles de provoquer des pertes de données stockées dans les mémoires. Dans le domaine de l'automobile, par exemple, des spécifications de stabilité des mémoires à haute température peuvent requérir que la mémoire garantisse une persistance de l'information qu'elle stocke pendant une durée supérieure à dix ans, à une température d'environ 150 °C, et pendant une durée d'environ deux heures, à une température d'environ 250 °C. Lorsqu'une mémoire à changement de phase est exposée à de telles températures, les cellules dont le matériau se trouve initialement dans la phase amorphe peuvent subir une cristallisation involontaire, donc une modification indésirable de leurs valeurs logiques, compromettant ainsi l'intégrité des données stockées dans la mémoire.

Afin de pallier cet inconvénient, des cellules mémoire à base d'un alliage de germanium, d'antimoine et de tellure (GeSbTe, également désigné par l'acronyme « GST ») comprenant une forte teneur en germanium, par exemple supérieure à 35 %, en pourcentage atomique, ont notamment été proposées. Dans ces cellules, la forte teneur en germanium permet de retarder la cristallisation du matériau à des températures élevées, par exemple supérieures à 250 °C. Toutefois, le fait de retarder la cristallisation du matériau pénalise, dans ces cellules, la transition entre la phase amorphe et la phase cristalline. Dans les cellules à base de GeSbTe à forte teneur en germanium, la transition depuis la phase amorphe conduit plutôt à la formation d'une phase polycristalline comprenant des grains constitués d'une phase stœchiométrique stable, par exemple une phase Ge₂Sb₂Te₅, GeSb₂Te₄, Sb₂Te₃, etc., séparés par des joints de grains riches en germanium. Cela entraîne une dérive très importante, dans le temps, de la résistance de la cellule mémoire, cette dérive étant aggravée par une exposition à des températures élevées. Dans ces cellules, la résistance de la phase censée être cristalline tend vers celle de la phase amorphe, et il devient alors très difficile de discriminer les deux états mémoire.

Un autre inconvénient des cellules mémoire à base d'un alliage GeSbTe à forte teneur en germanium tient au fait que, lorsque ces cellules subissent une étape d'initialisation visant à former une région active, par exemple en forme de champignon, à l'intérieur de chacune de ces cellules, une expulsion partielle du germanium présent en excès dans la région active et une formation de zones riches en germanium en périphérie de la région active sont observées. Cela fait apparaître, de manière indésirable, des hétérogénéités entre les cellules mémoire. Des exemples de l'art antérieur sont les documents US2016/072059 A1 et US2013/075682 A1.

### Résumé de l'invention

Il existe un besoin d'améliorer les cellules mémoire à changement de phase existantes. En particulier, il serait souhaitable de réaliser des cellules mémoire à changement de phase présentant une tenue en température améliorée sans pour autant que ces cellules ne soient affectées par une dérive de résistance lorsqu'elles se trouvent dans la phase cristalline.

Pour cela, un mode de réalisation prévoit une cellule mémoire à changement de phase de type confiné comprenant :
- une région isolante ;
- une première région confinée en un premier alliage de germanium, d'antimoine et de tellure entourée latéralement par la région isolante, le premier alliage formant entièrement la première région confinée ; et
- une deuxième région en un deuxième alliage de germanium, d'antimoine et de tellure, le deuxième alliage comprenant des proportions différentes des proportions du premier alliage, la deuxième région recouvrant la région isolante et la première région,
dans laquelle :
A) la cellule mémoire comprend en outre une troisième région en le deuxième alliage située du côté d'une face de la région isolante opposée à la deuxième région, la région isolante et la première région étant situées sur et en contact avec la troisième région ; et/ou
B) la première région présente une forme de U, l'intérieur du U formé par la première région étant entièrement rempli d'un matériau diélectrique, ou une forme de L.

Selon un mode de réalisation, la deuxième région est commune à plusieurs cellules mémoire, la première région de chaque cellule mémoire étant distincte de celles des autres cellules mémoire, chaque cellule mémoire comprenant en outre une électrode inférieure distincte de celles des autres cellules mémoire.

Selon un mode de réalisation, la deuxième région de chaque cellule mémoire est distincte de celles des autres cellules mémoire, chaque cellule mémoire comprenant en outre une électrode supérieure distincte de celles des autres cellules mémoire.

Selon un mode de réalisation, le premier alliage présente :
- une concentration atomique en germanium comprise entre 35 et 65 % ; et
- un rapport entre la concentration atomique en antimoine et la concentration atomique en tellure compris entre 1 et 5.

Selon un mode de réalisation, le deuxième alliage présente :
- une concentration atomique en germanium comprise entre 40 et 80 % ; et
- un rapport entre la concentration atomique en antimoine et la concentration atomique en tellure compris entre 0,2 et 1.

Selon un mode de réalisation :
- la première région présente une épaisseur supérieure à 5 nm, de préférence supérieure à 10 nm ; et
- la deuxième région présente une épaisseur supérieure à 5 nm, de préférence supérieure à 10 nm.

Selon un mode de réalisation, la deuxième région est située sur et en contact avec la région isolante et la première région.

Selon un mode de réalisation, la cellule comprend en outre une quatrième région en un troisième alliage de germanium, d'antimoine et de tellure différent des premier et deuxième alliages, interposée entre les première et deuxième régions.

Selon un mode de réalisation, la cellule comprend en outre une cinquième région en le troisième alliage, interposée entre les première et troisième régions.

Selon un mode de réalisation, un espaceur en nitrure de silicium revêt la face supérieure de la partie horizontale et un flanc de la partie verticale du L formé par chaque première région.

Selon un mode de réalisation, la première région présente une dimension latérale maximale strictement inférieure à celle de la deuxième région.

Selon un mode de réalisation, la première région présente une épaisseur strictement inférieure à celle de la deuxième région.

Un mode de réalisation prévoit un dispositif mémoire à changement de phase comprenant une pluralité de cellules mémoire telles que décrites.

Un mode de réalisation prévoit un procédé de fabrication d'une cellule mémoire à changement de phase comprenant les étapes successives suivantes :
a) former une région isolante ;
b) former une ouverture dans la région isolante ;
c) combler l'ouverture par une première région en un premier alliage de germanium, d'antimoine et de tellure entourée latéralement par la région isolante ; et
d) déposer, sur la région isolante et la première région, une deuxième région en un deuxième alliage de germanium, d'antimoine et de tellure, le deuxième alliage comprenant des proportions différentes des proportions du premier alliage, la deuxième région recouvrant la région isolante et la première région,
dans lequel :
A) le procédé comprend en outre, préalablement à l'étape a), une étape consistant à former une troisième région en le deuxième alliage, la région isolante et la première région étant ultérieurement formées sur et en contact avec la troisième région ; et/ou
B) la première région présente une forme de U, l'intérieur du U formé par la première région étant entièrement rempli d'un matériau diélectrique, ou une forme de L.

Selon un mode de réalisation, la cellule comprend un seul empilement de matériaux à changement de phase constitué des première et deuxième régions.

Selon un mode de réalisation, la cellule comprend un seul empilement de matériaux à changement de phase constitué des première, deuxième et troisième régions.

Selon un mode de réalisation, la cellule comprend en outre des première et deuxième électrodes situées de part et d'autre de la première région, l'une de ces électrodes étant située sur et en contact avec la deuxième région.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe, schématique et partielle, d'une cellule mémoire à changement de phase selon un mode de réalisation en dehors de l'invention ;
la figure 2 est un graphique représentant des teneurs en éléments chimiques d'alliages utilisés pour la réalisation de régions en matériau à changement de phase de la cellule de la figure 1 ;
la figure 3 est une vue en coupe, schématique et partielle, d'une structure obtenue à l'issue d'une étape d'initialisation de la cellule mémoire de la figure 1 ;
la figure 4 est une vue en coupe, schématique et partielle, d'une cellule mémoire à changement de phase selon un mode de réalisation ;
la figure 5 est une vue en coupe, schématique et partielle, d'une cellule mémoire à changement de phase selon un mode de réalisation ; et
la figure 6 est une vue en coupe, schématique et partielle, d'une structure comprenant deux cellules mémoire à changement de phase selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les éléments et circuits de commande des cellules mémoire à changement de phase des dispositifs mémoire décrits, pouvant notamment inclure des éléments de sélection et de connexion électrique, ne sont pas détaillés, les modes de réalisation décrits étant compatibles avec tous ou la plupart des éléments et circuits de commande de cellules mémoire à changement de phase usuels, moyennant éventuellement des adaptations à la portée de la personne du métier à la lecture de la présente description.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais « coupled ») entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes « avant », « arrière », « haut », « bas », « gauche », « droite », etc., ou relative, tels que les termes « dessus », « dessous », « supérieur », « inférieur », etc., ou à des qualificatifs d'orientation, tels que les termes « horizontal », « vertical », etc., il est fait référence, sauf précision contraire, à l'orientation des figures.

Sauf précision contraire, les expressions « environ », « approximativement », « sensiblement », et « de l'ordre de » signifient à 10 % près, de préférence à 5 % près.

Dans la description qui suit, les qualificatifs « isolant » et « conducteur » signifient respectivement, sauf précision contraire, électriquement isolant et électriquement conducteur.

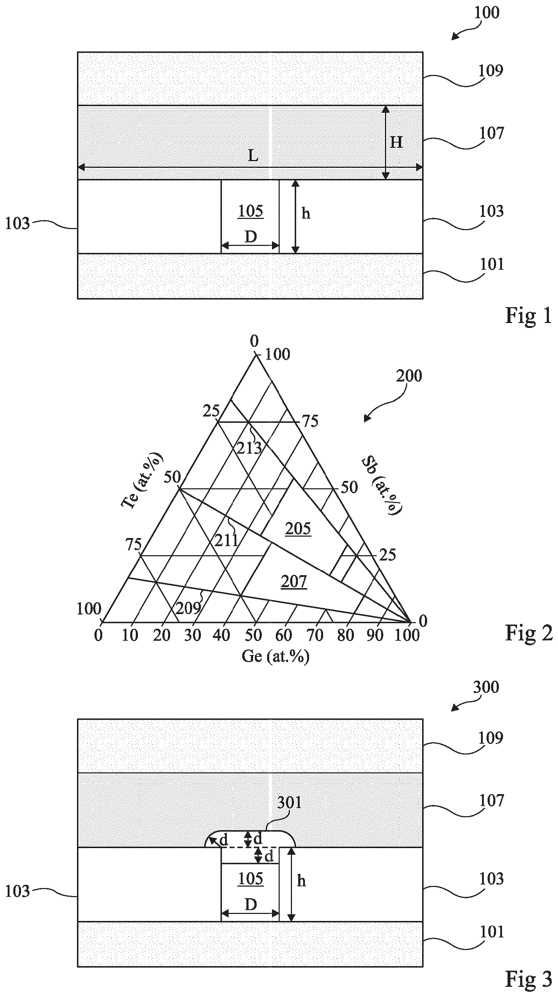

La figure 1 est une vue en coupe, schématique et partielle, d'une cellule mémoire à changement de phase 100 selon un mode de réalisation en dehors de l'invention. La cellule mémoire 100 fait par exemple partie d'un dispositif mémoire comprenant plusieurs cellules mémoire identiques ou analogues à la cellule mémoire 100, par exemple agencées en matrice selon des lignes et des colonnes. À titre d'exemple, le dispositif mémoire dont fait partie la cellule mémoire 100 comprend plusieurs milliers ou plusieurs millions de cellules mémoire. La figure 1 illustre plus particulièrement une cellule mémoire de type confiné.

Dans l'exemple représenté, la cellule mémoire 100 comprend une couche conductrice 101. La couche conductrice 101 constitue par exemple une première électrode (l'électrode inférieure, dans l'orientation de la figure 1), de la cellule mémoire 100. La couche conductrice 101 est par exemple située sur et en contact, par sa face inférieure, avec un sélecteur non représenté en figure 1. Dans ce cas, le sélecteur est par exemple un transistor, par exemple un transistor CMOS (de l'anglais « Complementary Metal-Oxide-Semiconductor » - métal oxyde semiconducteur complémentaire) ou un transistor bipolaire (« Bipolar Junction Transistor » - BJT, en anglais), ou une diode. La couche conductrice 101 présente, en vue de dessus, une forme quelconque, par exemple une forme rectangulaire, elliptique, carrée ou circulaire. À titre d'exemple, la couche conductrice 101 est en un métal ou en un alliage métallique.

Dans l'exemple illustré, la cellule mémoire 100 comprend en outre une région isolante 103 revêtant la couche conductrice 100. Dans cet exemple, la région isolante 103 est située sur et en contact avec la face supérieure de la couche conductrice 101. À titre d'exemple, la région isolante 103 est en un nitrure, par exemple le nitrure de silicium (SiN) ou le nitrure de germanium (GeN), ou en un oxyde, par exemple le dioxyde de silicium (SiO₂).

Dans l'exemple représenté, la cellule mémoire 100 comprend en outre une région confinée 105 en un matériau à changement de phase. Dans cet exemple, la région 105 est située dans la région isolante 103. Dans l'exemple illustré, la région 105 s'étend verticalement sur toute l'épaisseur de la région isolante 103, c'est-à-dire depuis une face de la région isolante 103 opposée à la couche conductrice 101 (la face supérieure de la région isolante 103, dans l'orientation de la figure 1) jusqu'à la face supérieure de la couche conductrice 101. Dans l'exemple représenté, la région 105 affleure la face supérieure de la région isolante 103. Par ailleurs, dans cet exemple, la région isolante 103 borde latéralement la région 105, la région isolante 103 étant située sur et en contact avec les parois latérales, ou flancs, de la région 105. Dans l'exemple illustré en figure 1, la région 105 est située sur et en contact avec une partie de la face supérieure de la couche conductrice 101 non revêtue par la région isolante 103. Dans l'exemple représenté, la région 105 en matériau à changement de phase comble, c'est-à-dire remplit intégralement, une ouverture ou cavité formée dans la région isolante 103. Dit autrement, le matériau à changement de phase forme entièrement la région confinée 105.

Dans l'exemple illustré, la région 105 en matériau à changement de phase présente une dimension latérale maximale D. La région 105 présente, en vue de dessus, une forme quelconque, par exemple identique à celle de la couche conductrice 101. La région 105 présente par exemple, en vue de dessus, une forme rectangulaire, elliptique, carrée ou circulaire. Dans ces cas, la dimension latérale maximale D de la région 105 correspond respectivement à la longueur, au grand axe, au côté ou au diamètre de la région 105. À titre d'exemple, la dimension D est comprise entre 1 et 100 nm, par exemple entre 10 et 50 nm. Par ailleurs, dans l'exemple illustré en figure 1, la région 105 présente une hauteur, ou épaisseur, sensiblement égale à une hauteur h, ou épaisseur, de la région isolante 103. À titre d'exemple, la hauteur h est supérieure à 5 nm, de préférence supérieure à 10 nm. La hauteur h est par exemple inférieure ou égale à 100 nm.

Dans l'exemple représenté, la cellule mémoire 100 comprend en outre une autre région 107 en un matériau à changement de phase différent de celui de la région 105. Dans l'exemple illustré, la région 107 revêt, ou recouvre, la région isolante 103. Dans cet exemple, la région 107 est située sur et en contact avec la face supérieure de la région isolante 103. Par ailleurs, la région 107 revêt, ou recouvre, la région 105 en matériau à changement de phase. Dans l'exemple illustré, la région 107 est située sur et en contact avec la face supérieure de la région 105.

Dans l'exemple illustré, la région 107 en matériau à changement de phase présente une hauteur, ou épaisseur, H et une dimension latérale maximale L. La hauteur H de la région 107 est par exemple supérieure à la hauteur h de la région 105. À titre d'exemple, la hauteur H est supérieure à 5 nm, de préférence supérieure à 10 nm. La hauteur H est par exemple inférieure ou égale à 200 nm. Par ailleurs, la dimension latérale maximale L de la région 107 est strictement supérieure, par exemple environ dix fois supérieure, à la dimension latérale maximale D de la région 105 sous-jacente. La région 107 présente, en vue de dessus, une forme quelconque, par exemple identique à celle de la couche conductrice 101 et/ou à celle de la région 105. La région 107 présente par exemple, en vue de dessus, une forme rectangulaire, elliptique, carrée ou circulaire. Dans ces cas, la dimension latérale maximale L de la région 107 correspond respectivement à la longueur, au grand axe, au côté ou au diamètre de la région 107. À titre d'exemple, la dimension L est comprise entre 5 et 500 nm, par exemple entre 20 et 300 nm.

Dans l'exemple représenté, la cellule mémoire 100 comprend en outre une autre couche conductrice 109. La couche conductrice 109 constitue par exemple une deuxième électrode (l'électrode supérieure, dans l'orientation de la figure 1), de la cellule mémoire 100. La couche conductrice 109 revêt par exemple la région 107 en matériau à changement de phase, la couche conductrice 109 étant par exemple située sur et en contact, par sa face inférieure, avec la face supérieure de la région 107. La couche conductrice 109 présente, en vue de dessus, une forme quelconque, par exemple identique à celle de la couche conductrice 101 et/ou à celle de la région 105 et/ou à celle de la région 107. La couche conductrice 109 présente par exemple, en vue de dessus, une forme rectangulaire, elliptique, carrée ou circulaire.

La couche conductrice 109 est par exemple en un métal, par exemple le tungstène, ou en un alliage métallique. À titre d'exemple, la couche conductrice 109 est en un nitrure métallique, par exemple le nitrure de titane (TiN) ou le nitrure de tantale (TaN). Par ailleurs, bien que cela n'ait pas été détaillé en figure 1, au moins une autre couche métallique intermédiaire, formant par exemple une électrode intermédiaire, peut être interposée entre la région 107 en matériau à changement de phase et la couche conductrice 109. Dans ce cas, chaque couche métallique intermédiaire est par exemple à base de titane ou de carbone.

Dans la cellule mémoire 100, la couche conductrice 101 est par exemple isolée de couches conductrices formant des électrodes inférieures d'autres cellules mémoire adjacentes identiques ou analogues à la cellule mémoire 100. Cela correspond par exemple à un cas où la couche conductrice 109 forme une électrode supérieure commune à plusieurs ou à toutes les cellules mémoire du dispositif mémoire auquel appartient la cellule mémoire 100. Dans ce cas, la cellule mémoire 100 présente par exemple des dimensions latérales sensiblement égales à celles de la couche conductrice 101.

À titre d'exemple, la couche conductrice 101 est un via conducteur connectant la région 105 en matériau à changement de phase de la cellule mémoire 100 à un élément de sélection, par exemple un transistor.

La région 107 est par exemple commune à plusieurs cellules mémoire 100 du dispositif mémoire. Dans ce cas, la région 105 de chaque cellule mémoire 100 est par exemple distincte des régions 105 des autres cellules mémoire 100, les régions 105 étant isolées les unes des autres. L'électrode inférieure de chaque cellule mémoire 100 est alors par exemple distincte des électrodes inférieures des autres cellules mémoire 100, les électrodes inférieures étant isolées les unes des autres.

À titre de variante, la région 107 de chaque cellule mémoire 100 peut être distincte des régions 107 des autres cellules mémoire 100, les régions 107 étant isolées les unes des autres. Par ailleurs, la couche conductrice 109 de chaque cellule mémoire 100 peut être distincte des couches conductrices 109 des autres cellules mémoire 100, les couches conductrices 109 étant isolées les unes des autres. Dans cette variante, la région 107 et/ou la couche conductrice 109 de chaque cellule mémoire 100 sont par exemple entourées d'un matériau isolant.

La cellule mémoire 100 est par exemple réalisée par la mise en œuvre d'un procédé de fabrication comprenant les étapes successives suivantes :
a) dépôt de la couche conductrice 101 ;
b) dépôt, du côté de la face supérieure de la couche conductrice 101, de la région isolante 103 ;
c) formation, par photolithographie puis gravure dans la région isolante 103, d'une cavité, ou ouverture, s'étendant verticalement dans l'épaisseur de la région isolante 103 depuis sa face supérieure jusqu'à la face supérieure de la couche conductrice 101, la cavité présentant une dimension latérale maximale D et une profondeur h ;
d) formation de la région 105 par dépôt, du côté de la face supérieure de la région isolante 103, d'une première couche en un premier matériau à changement de phase comblant la cavité formée à l'étape c) et s'étendant latéralement sur et en contact avec la face supérieure de la région isolante 103, puis planarisation, par exemple par polissage mécano-chimique (« Chemical Mechanical Polishing » - CMP, en anglais) afin d'éliminer des parties de la première couche revêtant la face supérieure de la région isolante 103 ;
e) dépôt, du côté de la face supérieure de la région isolante 103, d'une deuxième couche en un deuxième matériau à changement de phase ;
f) dépôt, du côté de la face supérieure de la deuxième couche en le deuxième matériau à changement de phase, de la couche conductrice 109 ; et
g) individualisation ou délimitation de la cellule mémoire 100 par photolithographie puis gravure de l'empilement formé par la région isolante 103, la deuxième couche en le deuxième matériau à changement de phase et la couche conductrice 109, conduisant ainsi à la formation de la région 107 de dimension latérale maximale L.

L'étape g) du procédé décrit ci-dessus est par exemple suivie d'une autre étape h) d'encapsulation de la cellule mémoire 100, comprenant par exemple le dépôt d'une couche isolante, par exemple en nitrure de silicium ou en dioxyde de silicium, revêtant la face supérieure et des flancs de la couche conductrice 109 ainsi que les flancs de la région 107 et de la région isolante 103. L'étape h) peut en outre être suivie d'une autre étape i) de formation d'éléments de reprise de contact sur la couche conductrice 109 à travers l'épaisseur de la couche isolante d'encapsulation.

La figure 2 est un graphique 200 représentant des teneurs, ou concentrations, en éléments chimiques d'alliages utilisés pour la réalisation de régions 105 et 107 en matériau à changement de phase de la cellule mémoire 100 de la figure 1. La figure 2 illustre plus précisément un cas dans lequel chaque région 105, 107 est en un alliage de germanium, d'antimoine et de tellure (GeSbTe, également désigné par l'acronyme « GST »).

Dans l'orientation de la figure 2, le graphique 200, de forme triangulaire pointant vers le haut, comprend des lignes horizontales permettant de représenter des variations de la teneur en antimoine (Sb), des lignes obliques permettant de représenter des variations de la teneur en germanium (Ge) et d'autres lignes obliques permettant de représenter des variations de la teneur en tellure (Te). Dans le graphique 200, les teneurs en germanium, antimoine et tellure dans les alliages des régions 105 et 107 sont exprimées en pourcentage atomique (at. %) et s'étendent, pour chaque élément chimique, sur une plage de 0 à 100 %.

Le graphique 200 comprend des zones 205 et 207 correspondant respectivement aux différentes compositions chimiques possibles pour la réalisation des alliages GeSbTe des régions 105 et 107 en matériau à changement de phase de la cellule mémoire 100. Les zones 205 et 207 correspondent plus particulièrement aux plages de pourcentages atomiques de germanium, antimoine et tellure entrant dans la composition des alliages GeSbTe des régions 105 et 107, respectivement.

Dans l'exemple représenté, la zone 205 regroupe des compositions d'alliages GeSbTe présentant une concentration atomique en germanium comprise entre 35 et 65 % et un rapport Sb/Te, entre la concentration atomique en antimoine et la concentration atomique en tellure, compris entre 1 et 5. Par ailleurs, dans cet exemple, la zone 207 regroupe des compositions d'alliages présentant une concentration atomique en germanium comprise entre 40 et 80 % et un rapport Sb/Te compris entre 0,2 et 1. En figure 2, le graphique 200 comprend une ligne 209 correspondant à un rapport Sb/Te égal à environ 0,2, une autre ligne 211 correspondant à un rapport Sb/Te égal à environ 1, et encore une autre ligne 213 correspondant à un rapport Sb/Te égal à environ 5.

Les alliages de germanium, d'antimoine et de tellure des régions 105 et 107 peuvent être dopés, par exemple par des atomes d'azote, de carbone, d'oxygène, de silicium, etc.

Un avantage de la cellule mémoire 100 tient au fait que le matériau à changement de phase de la région 105 permet de favoriser une phase cristalline ségrégée présentant une vitesse de croissance cristalline élevée, conduisant à une formation de cristallites de dimensions importantes. De plus, la teneur en germanium de ce matériau permet de garantir une bonne stabilité de la phase amorphe à haute température, par exemple pour des températures supérieures à 150 °C. Par ailleurs, le fait que la région 105 soit entourée, ou bordée, latéralement par la région isolante 103 permet d'atteindre des densités de courant plus importantes que dans la région 107, donc de former une phase amorphe dans la région 105 malgré le fait que le matériau présente un rapport Sb/Te compris entre 1 et 5.

Un autre avantage de la cellule mémoire 100 réside dans le fait que le matériau à changement de phase de la région 107 permet de limiter ou d'empêcher des phénomènes d'expulsion de germanium depuis la région 105 sous l'effet de l'élévation de température appliquée à la cellule mémoire 100 lors d'une étape de programmation de la cellule. Cela garantit une bonne stabilité thermique dans la région 105. Par ailleurs, le matériau à changement de phase de la région 107 assure une bonne conduction électrique entre les couches conductrices 101 et 109 et la région 105. Le matériau de la région 107 permet en outre de limiter ou d'empêcher le tellure de la région 105 de migrer, par diffusion, dans la région 107.

La figure 3 est une vue en coupe, schématique et partielle, d'une structure 300 obtenue à l'issue d'une étape d'initialisation de la cellule mémoire 100 de la figure 1. À titre de variante, la structure 300 de la figure 3 peut être obtenue au cours de la fabrication de la cellule mémoire 100.

La structure 300 de la figure 3 comprend des éléments communs avec la cellule mémoire 100 de la figure 1. Ces éléments communs ne seront pas détaillés à nouveau ci-après. La structure 300 de la figure 3 diffère de la cellule mémoire 100 de la figure 1 en ce que la structure 300 comprend une région 301 en matériau à changement de phase interposée entre les régions 105 et 107.

Dans l'exemple représenté, une première partie de la région 301 présente, en vue de dessus, une forme et des dimensions latérales sensiblement identiques à celles de la région 105 et s'étend verticalement dans l'épaisseur de la région isolante 103, depuis sa face supérieure vers sa face inférieure, jusqu'à une profondeur d inférieure à l'épaisseur h de la région isolante 103. Dans cet exemple, la région 105 présente une hauteur, ou épaisseur, égale à l'épaisseur h de la région isolante 103 moins l'épaisseur d de la première partie de la région 301. À titre d'exemple, l'épaisseur d est inférieure ou égale à 10 % de l'épaisseur h de la région isolante 103.

Par ailleurs, dans l'exemple illustré, une deuxième partie de la région 301 présente, en vue de dessus, des dimensions latérales strictement supérieures à celles de la région 105 et s'étend verticalement, dans l'épaisseur de la région 107, depuis sa face inférieure vers sa face supérieure, sur une distance par exemple sensiblement égale à l'épaisseur d de la première partie de la région 301. Dans cet exemple, la deuxième partie de la région 301 présente, en vue de dessus, une forme sensiblement identique à celle de la région 105 et une dimension latérale maximale égale à la dimension latérale maximale de la région 105 plus deux fois l'épaisseur d.

Le matériau à changement de phase de la région 301 est différent de celui des régions 105 et 107. La région 301 est par exemple en un alliage GeSbTe présentant une composition chimique intermédiaire entre celle de l'alliage de la région 105 sous-jacente et celle de l'alliage de la région 107 sus-jacente, autrement dit des teneurs en germanium, antimoine et tellure comprises entre celles du matériau à changement de phase de la région 105 et celles du matériau à changement de phase de la région 107. L'alliage de la région 301 présente par exemple plus précisément une teneur en germanium et un rapport Sb/Te compris entre ceux des alliages 205 et 207 des régions 105 et 107, respectivement.

Dans le cas où la structure 300 est obtenue à l'issue d'une étape d'initialisation de la cellule mémoire 100 de la figure 1, la région 301 est par exemple formée sous l'effet d'un échauffement produit par un courant circulant entre les couches conductrices 101 et 109 de la cellule mémoire 100, conduisant à un mélange des matériaux des régions 105 et 107 au voisinage d'une interface entre ces régions. Dans un cas où la structure 300 est obtenue au cours de la fabrication de la cellule mémoire 100, la région 301 est par exemple formée, par exemple lors d'une étape mise en œuvre entre les étapes d) et e) du procédé précédemment décrit en relation avec la figure 1, par une opération de dépôt d'une troisième couche en un troisième matériau à changement de phase à l'intérieur de la cavité suivie d'opérations de photolithographie puis gravure de la troisième couche.

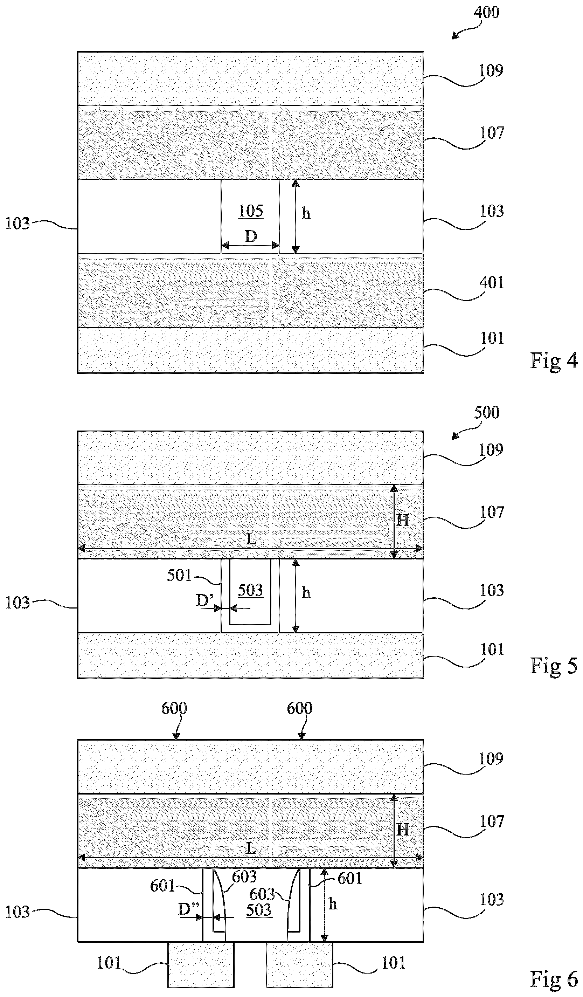

La figure 4 est une vue en coupe, schématique et partielle, d'une cellule mémoire à changement de phase 400 selon un mode de réalisation de l'invention.

La cellule mémoire 400 de la figure 4 comprend des éléments communs avec la cellule mémoire 100 de la figure 1. Ces éléments communs ne seront pas détaillés à nouveau ci-après. La cellule mémoire 400 de la figure 4 diffère de la cellule mémoire 100 de la figure 1 en ce que la cellule mémoire 400 comprend en outre une autre région 401 en un matériau à changement de phase, différent de celui de la région 105, interposée verticalement entre la couche conductrice 101 et la région 105. Le matériau à changement de phase de la région 401 est par exemple sensiblement identique à celui de la région 107.

Dans l'exemple illustré, la région 401 revêt la couche conductrice 101, la région 401 étant plus précisément située sur et en contact avec la face supérieure de la couche conductrice 101. Dans cet exemple, la région isolante 103 et la région 105 en matériau à changement de phase sont situées sur et en contact avec la face supérieure de la région 401. La région 401 en matériau à changement de phase présente par exemple une hauteur, ou épaisseur, et une dimension latérale maximale sensiblement égales, respectivement, à la hauteur H et à la dimension latérale maximale L de la région 107 en matériau à changement de phase. La région 401 présente, en vue de dessus, une forme quelconque, par exemple identique à celle de la région 107.

La présence de la région 401 dans la cellule mémoire 400 permet avantageusement, par rapport à la cellule mémoire 100, d'obtenir une meilleure isolation thermique de la région 105 en matériau à changement de phase. Il en résulte que la cellule mémoire 400 requiert une quantité d'énergie moindre que la cellule mémoire 100 pour produire, dans la région 105, un échauffement sensiblement identique. La cellule mémoire 400 présente donc une efficacité énergétique supérieure à celle de la cellule mémoire 100.

La figure 5 est une vue en coupe, schématique et partielle, d'une cellule mémoire à changement de phase 500 selon un mode de réalisation de l'invention.

La cellule mémoire 500 de la figure 5 comprend des éléments communs avec la cellule mémoire 100 de la figure 1. Ces éléments communs ne seront pas détaillés à nouveau ci-après. La cellule mémoire 500 de la figure 5 diffère de la cellule mémoire 100 de la figure 1 en ce que la cellule mémoire 500 comprend, à la place de la région 105, une région 501 en matériau à changement de phase formée dans l'épaisseur de la région isolante 103.

Dans l'exemple représenté, la région 501 présente, en vue de côté et en coupe, une forme de U comprenant des parties verticales, s'étendant verticalement sur toute l'épaisseur h de la région isolante 103, et une partie horizontale, s'étendant latéralement sur et en contact avec une partie de la face supérieure de la couche conductrice 101. Les parties verticales de la région 501 présentent chacune une largeur D' et sont séparées latéralement l'une de l'autre par une région isolante 503. La région isolante 503 est par exemple en le même matériau que la région isolante 103. Dans l'exemple représenté, la région isolante 503 est située sur et en contact avec les faces latérales internes et le fond du U formé par la région 501. En vue de dessus, la région 503 est interposée latéralement entre deux bandes sensiblement parallèles correspondant aux flancs de la région 501. Dit autrement, l'intérieur du U formé par la région 501 est entièrement rempli d'un matériau diélectrique (le matériau de la région isolante 503, dans cet exemple). À titre d'exemple, les parois verticales du U formé par la région 501 présentent, en vue de dessus, une forme rectangulaire, elliptique, carrée ou circulaire.

À titre d'exemple, la région 501 est formée lors d'une étape analogue à l'étape d) du procédé précédemment décrit en relation avec la figure 1, dans laquelle la première couche en le premier matériau à changement de phase revêt les parois latérales, ou flancs, et le fond de la cavité formée à l'étape c) mais ne comble pas, c'est-à-dire ne remplit pas entièrement, la cavité. La région isolante 503 est par exemple ensuite formée par dépôt d'une autre couche isolante du côté de la face supérieure de la structure, l'autre couche isolante et la première couche étant par exemple ensuite planarisées, par exemple par CMP avec arrêt sur la face supérieure de la région isolante 103.

La cellule mémoire 500 présente des avantages analogues ou identiques à ceux de la cellule mémoire 100.

La figure 6 est une vue en coupe, schématique et partielle, d'une structure comprenant deux cellules mémoire à changement de phase 600 selon un mode de réalisation de l'invention.

La structure de la figure 6 comprend des éléments communs avec la cellule mémoire 500 de la figure 5. Ces éléments communs ne seront pas détaillés à nouveau ci-après. La structure de la figure 6 diffère de la cellule mémoire 500 de la figure 5 en ce que la structure de la figure 6 comprend deux régions 601 en matériau à changement de phase formées chacune dans l'épaisseur de la région isolante 103.

Dans l'exemple représenté, chaque région 601 présente une forme de L comprenant une partie verticale, s'étendant verticalement sur toute l'épaisseur h de la région isolante 103, et une partie horizontale, s'étendant latéralement sur et en contact avec une partie de la face supérieure de la couche conductrice 101. Dans cet exemple, la couche conductrice 101 est discontinue et chaque cellule mémoire 600 comprend une portion de couche conductrice 101 isolée de portions de couche conductrice 101 faisant partie des autres cellules mémoire. La partie verticale de la région 601 présente une largeur D". Dans l'exemple représenté, les L formés par les régions 601 des cellules mémoire 600 sont symétriques par rapport à un axe vertical équidistant des portions de couche conductrice 101, et sont séparés latéralement l'un de l'autre par la région isolante 503. À titre d'exemple, les parois verticales des L formés par les régions 601 présentent, en vue de dessus, une forme rectangulaire, elliptique, carrée ou circulaire.

Dans l'exemple représenté, une région isolante 603 revêt la face supérieure de la partie horizontale et un flanc de la partie verticale du L formé par chaque région 601. La région isolante 603 constitue par exemple une structure de type espaceur (« spacer », en anglais). À titre d'exemple, la région 603 est en un nitrure, par exemple le nitrure de silicium, le nitrure de gallium (GaN) ou le nitrure de silicium-carbone (SiCN), ou en carbure de silicium (SiC).

À titre d'exemple, les régions 601 des cellules mémoire 600 de la figure 6 sont formées à partir de la région 501 précédemment décrite en relation avec la figure 5, par exemple par photolithographie puis gravure de la partie horizontale du U formé par la région 501. Les régions isolantes 603 sont par exemple ensuite formées par dépôt puis gravure d'une couche isolante avant formation de la région isolante 503, par exemple comme exposé ci-dessus en relation avec la figure 5. Ainsi, dans l'exemple illustré en figure 6, deux cellules mémoire 600 sont par exemple obtenues à partir d'une même cavité.

Les cellules mémoire 600 présentent des avantages analogues ou identiques à ceux de la cellule mémoire 100.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, la cellule mémoire 400 de la figure 4 peut présenter, à l'issue d'une étape d'initialisation de la cellule mémoire 400 ou au cours de la fabrication de la cellule mémoire 400, une structure analogue à la structure 300 décrite en relation avec la figure 3. Dans ce cas, la cellule mémoire 400 comprend par exemple la région 301 en matériau à changement de phase, interposée verticalement entre les régions 105 et 107, et une autre région en matériau à changement de phase, analogue à la région 301, interposée verticalement entre les régions 105 et 401 et formant le symétrique de la région 301 par rapport à un axe horizontal traversant la région isolante 103 en son milieu.

Par ailleurs, le mode de réalisation de la figure 4 est combinable avec les modes de réalisation des figures 5 et 6. Cela revient par exemple à prévoir, dans la cellule mémoire 500 ou 600, une région en un matériau à changement de phase analogue ou identique à la région 401 de la cellule mémoire 400, la région en matériau à changement de phase étant alors interposée entre la couche conductrice 101 et la région 501, pour la cellule mémoire 500, ou la région 601, pour la cellule mémoire 600.

Enfin, la mise en œuvre pratique des modes de réalisation et variantes décrits est à la portée de la personne du métier à partir des indications fonctionnelles données ci-dessus. En particulier, la composition chimique de chaque région 105, 107, 301, 401, 501, 601 en matériau à changement de phase est ajustable par la personne du métier, par exemple en fonction de l'application visée, à partir des indications de la présente description.

Par ailleurs, les modes de réalisation décrits ne se limitent pas aux exemples particuliers de matériaux et de dimensions mentionnés dans la présente description.

## Revendications

1. Cellule mémoire à changement de phase (400 ; 500 ; 600) de type confiné comprenant :
- une région isolante (103) ;
- une première région (105 ; 501 ; 601) confinée en un premier alliage (205) de germanium, d'antimoine et de tellure entourée latéralement par la région isolante, le premier alliage formant entièrement la première région confinée ; et
- une deuxième région (107) en un deuxième alliage (207) de germanium, d'antimoine et de tellure, le deuxième alliage comprenant des proportions différentes des proportions du premier alliage, la deuxième région recouvrant la région isolante et la première région, **caractérisé en ce que**
A) la cellule mémoire (400) comprend en outre une troisième région (401) en le deuxième alliage (207) située du côté d'une face de la région isolante (103) opposée à la deuxième région (107), la région isolante (103) et la première région (105) étant situées sur et en contact avec la troisième région ; et/ou
B) la première région (501 ; 601) présente une forme de U, l'intérieur du U formé par la première région étant entièrement rempli d'un matériau diélectrique, ou une forme de L.

2. Cellule (400 ; 500 ; 600) selon la revendication 1, dans laquelle le premier alliage (205) présente :
- une concentration atomique en germanium comprise entre 35 et 65 % ; et
- un rapport entre la concentration atomique en antimoine et la concentration atomique en tellure compris entre 1 et 5.

3. Cellule (400 ; 500 ; 600) selon la revendication 1 ou 2, dans laquelle le deuxième alliage (207) présente :
- une concentration atomique en germanium comprise entre 40 et 80 % ; et
- un rapport entre la concentration atomique en antimoine et la concentration atomique en tellure compris entre 0,2 et 1.

4. Cellule (400 ; 500 ; 600) selon l'une quelconque des revendications 1 à 3, dans laquelle :
- la première région (105 ; 501 ; 601) présente une épaisseur (h) supérieure à 5 nm, de préférence supérieure à 10 nm ; et
- la deuxième région (107) présente une épaisseur (H) supérieure à 5 nm, de préférence supérieure à 10 nm.

5. Cellule (400 ; 500 ; 600) selon l'une quelconque des revendications 1 à 4, dans laquelle la deuxième région (107) est située sur et en contact avec la région isolante (103) et la première région (105 ; 501 ; 601).

6. Cellule selon l'une quelconque des revendications 1 à 4, comprenant en outre une quatrième région en un troisième alliage de germanium, d'antimoine et de tellure différent des premier et deuxième alliages (205, 207), interposée entre les première (105 ; 501 ; 601) et deuxième (107) régions.

7. Cellule (400) selon la revendication 6 dans l'option A), comprenant en outre une cinquième région en le troisième alliage, interposée entre les première (105) et troisième (401) régions.

8. Cellule (600) selon l'une quelconque des revendications 1 à 7 dans l'option B), dans laquelle un espaceur (603) en nitrure de silicium revêt la face supérieure de la partie horizontale et un flanc de la partie verticale du L formé par chaque première région (601).

9. Cellule (400 ; 500 ; 600) selon l'une quelconque des revendications 1 à 8, dans laquelle la première région présente une dimension latérale maximale (D ; D' ; D") strictement inférieure à celle (L) de la deuxième région (107).

10. Cellule (400 ; 500 ; 600) selon l'une quelconque des revendications 1 à 9, dans laquelle la première région (105 ; 501 ; 601) présente une épaisseur (h) strictement inférieure à celle (H) de la deuxième région (107).

11. Dispositif mémoire à changement de phase comprenant une pluralité de cellules mémoire (400 ; 500 ; 600) selon l'une quelconque des revendications 1 à 10.

12. Procédé de fabrication d'une cellule mémoire à changement de phase (400 ; 500 ; 600) comprenant les étapes successives suivantes :
a) former une région isolante (103) ;
b) former une ouverture dans la région isolante ;
c) combler l'ouverture par une première région (105 ; 501 ; 601) en un premier alliage (205) de germanium, d'antimoine et de tellure entourée latéralement par la région isolante ; et
d) déposer, sur la région isolante et la première région, une deuxième région (107) en un deuxième alliage (207) de germanium, d'antimoine et de tellure, le deuxième alliage comprenant des proportions différentes des proportions du premier alliage, la deuxième région recouvrant la région isolante et la première région,
**caractérisé en ce que** :
A) le procédé comprend en outre, préalablement à l'étape a), une étape consistant à former une troisième région (401) en le deuxième alliage (207), la région isolante (103) et la première région (105) étant ultérieurement formées sur et en contact avec la troisième région ; et/ou
B) la première région (501 ; 601) présente une forme de U, l'intérieur du U formé par la première région étant entièrement rempli d'un matériau diélectrique, ou une forme de L.

## Patentansprüche

1. Eine Phasenwechsel-Speicherzelle (400; 500; 600) vom begrenzten Typ, aufweisend:
- einen isolierenden Bereich (103);
- einen ersten begrenzten Bereich (105; 501; 601) aus einer ersten Legierung (205) aus Germanium, Antimon und Tellur, der seitlich von dem isolierenden Bereich umgeben ist, wobei die erste Legierung den gesamten ersten begrenzten Bereich bildet; und
- einen zweiten Bereich (107) aus einer zweiten Legierung (207) aus Germanium, Antimon und Tellur, wobei die zweite Legierung andere Anteile als die erste Legierung aufweist und der zweite Bereich den Isolierbereich und den ersten Bereich überlappt,
**dadurch gekennzeichnet, dass**:
A) die Speicherzelle (400) ferner einen dritten Bereich (401) aus der zweiten Legierung (207) aufweist, der sich auf der Seite einer Fläche des isolierenden Bereichs (103) entgegengesetzt zum zweiten Bereich (107) befindet, wobei der isolierende Bereich (103) und der erste Bereich (105) auf und in Kontakt mit dem dritten Bereich angeordnet sind; und/oder
B) der erste Bereich (501; 601) U-förmig ist, wobei das Innere des durch den ersten Bereich gebildeten U vollständig mit einem dielektrischen Material gefüllt ist, oder L-förmig ist.

2. Zelle (400; 500; 600) gemäß Anspruch 1, wobei die erste Legierung (205) Folgendes aufweist:
- eine Atomkonzentration von Germanium zwischen 35 und 65 %; und
- ein Verhältnis der Atomkonzentration von Antimon zur Atomkonzentration von Tellur zwischen 1 und 5.

3. Zelle (400; 500; 600) gemäß Anspruch 1 oder 2, wobei die zweite Legierung (207) Folgendes aufweist:
- eine Atomkonzentration von Germanium zwischen 40 und 80 %; und
- ein Verhältnis der Atomkonzentration von Antimon zur Atomkonzentration von Tellur zwischen 0,2 und 1.

4. Zelle (400; 500; 600) gemäß einem der Ansprüche 1 bis 3, wobei:
- der erste Bereich (105; 501; 601) eine Dicke (h) von größer als 5 nm, vorzugsweise größer als 10 nm, aufweist; und
- der zweite Bereich (107) eine Dicke (H) von größer als 5 nm, vorzugsweise größer als 10 nm, aufweist.

5. Zelle (400; 500; 600) gemäß einem der Ansprüche 1 bis 4, wobei der zweite Bereich (107) auf und in Kontakt mit dem isolierenden Bereich (103) und dem ersten Bereich (105; 501; 601) angeordnet ist.

6. Zelle gemäß einem der Ansprüche 1 bis 4, die ferner folgendes aufweist: einen vierten Bereich aus einer dritten Legierung aus Germanium, Antimon und Tellur, die sich von der ersten und zweiten Legierung (205, 207) unterscheidet und zwischen dem ersten (105; 501; 601) und dem zweiten (107) Bereich angeordnet ist.

7. Zelle (400) gemäß Anspruch 6 gemäß Option A), die ferner einen fünften Bereich aus der dritten Legierung aufweist, der zwischen dem ersten (105) und dem dritten (401) Bereich angeordnet ist.

8. Zelle (600) gemäß einem der Ansprüche 1 bis 7 gemäß Option B), wobei ein Abstandshalter (603) aus Siliziumnitrid die Oberseite des horizontalen Abschnitts und eine Flanke des vertikalen Abschnitts des L bedeckt, das durch jeden ersten Bereich (601) gebildet wird.

9. Zelle (400; 500; 600) gemäß einem der Ansprüche 1 bis 8, wobei der erste Bereich eine maximale seitliche Abmessung (D; D'; D") aufweist, die streng kleiner ist als die (L) des zweiten Bereichs (107).

10. Zelle (400; 500; 600) gemäß einem der Ansprüche 1 bis 9, wobei der erste Bereich (105; 501; 601) eine Dicke (h) aufweist, die streng kleiner ist als die (H) des zweiten Bereichs (107).

11. Phasenwechsel-Speichervorrichtung, die eine Vielzahl von Speicherzellen (400; 500; 600) gemäß einem der Ansprüche 1 bis 10 aufweist.

12. Verfahren zur Herstellung einer Phasenwechsel-Speicherzelle (400; 500; 600), das die folgenden aufeinanderfolgenden Schritte aufweist:
a) Ausbilden eines isolierenden Bereichs (103);
b) Ausbilden einer Öffnung in dem isolierenden Bereich;
c) Füllen der Öffnung mit einem ersten Bereich (105; 501; 601) aus einer ersten Legierung (205) aus Germanium, Antimon und Tellur, der seitlich von dem isolierenden Bereich umgeben ist; und
d) Aufbringen eines zweiten Bereichs (107) aus einer zweiten Legierung (207) aus Germanium, Antimon und Tellur auf dem isolierenden Bereich und dem ersten Bereich, wobei die zweite Legierung andere Anteile als die erste Legierung aufweist, und der zweite Bereich den isolierenden Bereich und den ersten Bereich überlappt,
**dadurch gekennzeichnet, dass**:
A) das Verfahren ferner vor Schritt a) einen Schritt aufweist, der darin besteht, einen dritten Bereich (401) aus der zweiten Legierung (207) auszubilden, wobei der isolierende Bereich (103) und der erste Bereich (105) anschließend auf dem dritten Bereich und in Kontakt mit diesem ausgebildet werden; und/oder
B) der erste Bereich (501; 601) U-förmig ist, wobei das Innere des durch den ersten Bereich gebildeten U vollständig mit einem dielektrischen Material gefüllt ist, oder L-förmig ist.

## Claims

1. A phase-change memory cell (400; 500; 600) of the confined type comprising:
- an insulating region (103);
- a first confined region (105; 501; 601) made of a first alloy (205) of germanium, antimony, and tellurium laterally surrounded by the insulating region, the first alloy forming entirely the first confined region; and
- a second region (107) made of a second alloy (207) of germanium, antimony, and tellurium, the second alloy comprising proportions different from the proportions of the first alloy, the second region overlapping the insulating region and the first region,
**characterized in that**:
A) the memory cell (400) further comprises a third region (401) made of the second alloy (207) located on the side of a face of the insulating region (103) opposite the second region (107), the insulating region (103) and the first region (105) being located on, and in contact with, the third region; and/or
B) the first region (501; 601) is U-shaped, the interior of the U formed by the first region being completely filled with a dielectric material, or L-shaped.

2. The cell (400; 500; 600) according to claim 1, wherein the first alloy (205) has:
- an atomic concentration of germanium of between 35 and 65%; and
- a ratio of atomic concentration of antimony to atomic concentration of tellurium of between 1 and 5.

3. The cell (400; 500; 600) according to claim 1 or 2, wherein the second alloy (207) has:
- an atomic concentration of germanium of between 40 and 80%; and
- a ratio of atomic concentration of antimony to atomic concentration of tellurium of between 0.2 and 1.

4. The cell (400; 500; 600) according to any one of claims 1 to 3, wherein:
- the first region (105; 501; 601) has a thickness (h) higher than 5 nm, preferably higher than 10 nm; and
- the second region (107) has a thickness (H) higher than 5 nm, preferably higher than 10 nm.

5. The cell (400; 500; 600) according to any one of claims 1 to 4, wherein the second region (107) is located on, and in contact with, the insulating region (103) and the first region (105; 501; 601).

6. The cell according to any one of claims 1 to 4, further comprising a fourth region made of a third alloy of germanium, antimony, and tellurium different from the first and second alloys (205, 207), interposed between the first (105; 501; 601) and second (107) regions.

7. The cell (400) according to claim 6 in option A), further comprising a fifth region made of the third alloy, interposed between the first (105) and third (401) regions.

8. The cell (600) according to any one of claims 1 to 7 in option B), wherein a spacer (603) made of silicon nitride coats the upper face of the horizontal portion and a flank of the vertical portion of the L formed by each first region (601).

9. The cell (400; 500; 600) according to any one of claims 1 to 8, wherein the first region has a maximum lateral dimension (D; D'; D") strictly smaller than that (L) of the second region (107).

10. The cell (400; 500; 600) according to any one of claims 1 to 9, wherein the first region (105; 501; 601) has a thickness (h) strictly less than that (H) of the second region (107).

11. A phase-change memory device comprising a plurality of memory cells (400; 500; 600) according to any one of claims 1 to 10.

12. A method of manufacturing a phase-change memory cell (400; 500; 600) comprising the following successive steps:
a) forming an insulating region (103);
b) forming an opening in the insulating region;
c) filling the opening with a first region (105; 501; 601) made of a first alloy (205) of germanium, antimony, and tellurium laterally surrounded by the insulating region; and
d) depositing, on the insulating region and the first region, a second region (107) of a second alloy (207) of germanium, antimony, and tellurium, the second alloy comprising proportions different from the proportions of the first alloy, the second region overlapping the insulating region and the first region,
**characterized in that**:
A) the method further comprises, prior to step a), a step consisting of forming a third region (401) made of the second alloy (207), the insulating region (103) and the first region (105) being subsequently formed on, and in contact with, the third region; and/or
B) the first region (501; 601) is U-shaped, the interior of the U formed by the first region being completely filled with a dielectric material, or L-shaped.
